# EUROPEAN PATENT APPLICATION

(11) **EP 1 244 154 A2**
(43) Date of publication of application: **25.09.2002**
(21) Application number: 02252028.2
(22) Date of filing: 21.03.2002
(51) Int. Cl.: H01L 51/20

(54) **Organic electroluminescence device and manufacturing method thereof**

(30) Priority: 22.03.2001 JP 2001083436
(71) Applicant: Sanyo Electric Co., Ltd., Moriguchi-shi, Osaka 570-8677 (JP)
(72) Inventor: Hamada, Yuji, Moriguchi-shi, Osaka 570-8677 (JP); Ogura, Morio, Moriguchi-shi, Osaka 570-8677 (JP)
(74) Representative: Calderbank, Thomas Roger

(57) **Abstract**

A metal oxide film is formed on a hole injection electrode. A hole injection layer, a luminescent layer, and an electron transport layer each made of an organic material are formed in this order on the metal oxide film. An electron injection electrode is formed on the electron transport layer. The metal oxide film is made of gallium oxide, tantalum oxide, lanthanum oxide, indium oxide, tin oxide or platinum oxide. The thickness of the metal oxide film is preferably in the range from 1 Å to 100 Å, more preferably in the range from 5 Å to 20 Å, and even more preferably about 10 Å. The metal oxide film is formed by helicon sputtering.

## Description

The present invention relates to an organic electroluminescence device and a manufacturing method thereof.

The organic electroluminescence device (hereinafter referred to as "organic EL device") is expected as a new type self light emitting device. The organic EL device has a layered structure including a carrier transport layer (electron or hole transport layer) between a hole injection electrode and an electron injection electrode, and a luminescent layer.

An electrode material having a large work function such as gold or ITO (Indium-Tin Oxide) is used for the hole injection electrode, while an electrode material having a small work function such as Mg (magnesium) or Li (lithium) is used for the electron injection electrode.

An organic material is used for the hole transport layer, the luminescent layer and the electron transport layer. A material having the characteristic of p-type semiconductor is used for the hole transport layer, while a material having the characteristic of n-type semiconductor is used for the electron transport layer. The luminescent layer also has carrier transportability similar to the electron or hole transportability, and is made of an organic material emitting fluorescent light or phosphorescent light.

The hole injection electrode, the hole transport layer, the luminescent layer, the electron transport layer and the electron injection electrode are layered in this order to form the organic EL device.

Note that depending upon organic materials to be used, these functional layers such as the hole transport layer, electron transport layer and luminescent layer may each include a plurality of layers or some of them may not be provided at all.

In the device disclosed in Chihaya Adachi et al., *Appl. Phys. Lett.,* Vol. 55, pp. 1489 to 1491, 1989, there are only two organic layers, a luminescent layer and an electron transport layer between the hole injection electrode and the electron injection electrode. This is because the luminescent layer made of a luminescent material called NSD has good hole transportability and can therefore also serve as a hole transport layer.

The device disclosed in C. W. Tang et al., *Appl. Phys. Lett.*, Vol. 51, pp. 913 to 915, 1987 includes two organic layers, a hole transport layer and a luminescent layer. In this case, the tris (8-hydroxyquinolinato) aluminum (hereinafter referred to as "Alq") of the luminescent layer serves two functions, i.e., emitting light and transporting electrons.

Meanwhile, the device disclosed in S. A. VanSlyke et al., *Appl. Phys. Lett.,* Vol. 69, pp. 2160 to 2162, 1996 includes three organic layers, a hole injection layer, a hole transport layer and a luminescent layer. In this case, the hole injection layer is made of copper phthalocyanine and functions similarly to the hole transport layer, in other words, there are two hole transport layers in the device as a whole.

As described, depending upon organic materials to be used, the number of electron transport layers, hole transport layers and luminescent layers may be adjusted as desired.

In the luminance-voltage characteristic of organic EL devices in general, the rising of the luminance curve in response to voltage increase is often abrupt. The abrupt rising in the luminance curve in response to voltage increase could be a disadvantage in terms of the applicability of the organic EL devices to displays.

If the rising of the luminance curve in response to voltage increase is abrupt, the luminance greatly changes in response to even a small voltage change. The significant change in the luminance in response to a small voltage change could cause luminance unevenness on the screen of the display.

In this case, it is difficult to control the luminance with high precision because of the design of the driving circuit in the organic EL device. This disadvantage is common to both cases of using high and low molecular organic materials.

It is an object of the present invention to provide an organic electroluminescence device which can alleviate the abruptness in the rising of the luminance in response to voltage increase in the luminance-characteristic curve and provide high luminous efficiency, and a manufacturing method thereof.

An organic electroluminescence device according to one aspect of the present invention includes a hole injection electrode, a metal oxide film, a luminescent layer, and an electron injection electrode in this order.

When there are excess holes in an organic electroluminescence device, many holes are not re-combined and directly passed to an electron injection electrode. This lowers the luminous efficiency.

In the organic electroluminescence device according to the present invention, the metal oxide film is provided between the hole injection electrode and the luminescent layer, so that the metal oxide film can restrain holes from being injected from the hole injection electrode. This improves the charge balance (the balance of positive and negative charges) in the device. As a result, the abruptness in the rising of the luminance in response to voltage increase in the luminance-voltage characteristic is alleviated and higher luminous efficiency is provided.

The metal oxide film is preferably made of a metal oxide selected from the group consisting of gallium oxide, tantalum oxide, lanthanum oxide, indium oxide, tin oxide, and platinum oxide. In this case, the metal oxide film can be thin and dense.

The metal oxide film preferably has a thickness in the range from 1 Å to 100 Å. In this case, the metal oxide film can restrain holes from being injected into the luminescent layer from the hole injection electrode, while some holes are injected into the luminescent layer from the hole injection electrode by the tunneling effect. If the film thickness is larger than 100 Å, holes are extremely restrained from being injected, and then the luminous efficiency is lowered rather than improved. If the film thickness is smaller than 1 Å, the effect of alleviating the abruptness in the rising of the luminance in response to voltage increase in the luminance-voltage characteristic is weakened.

The metal oxide film more preferably has a thickness in the range from 5 Å to 20 Å. In this case, the abruptness in the rising of the luminance in response to voltage increase in the luminance-voltage characteristic is more alleviated and higher luminous efficiency is provided.

The organic electroluminescence device may further include a hole injection layer provided between the metal oxide film and the luminescent layer. In this case, the metal oxide film restrains holes from being injected into the hole injection layer from the hole injection electrode. As a result, the abruptness in the rising of the luminance in response to voltage increase in the luminance-voltage characteristic is more alleviated and higher luminous efficiency is provided.

The hole injection layer may include an amine-based material. The organic electroluminescence device may further include an electron transport layer provided between the luminescent layer and the electron injection electrode. The electron transport layer may include tris (8-hydroxyquinolinato) aluminum (hereinafter referred to as "Alq").

Holes are easily passed particularly when an amine-based material is used for the hole transport material and Alq is used for the electron transport material. Therefore, there are excessive holes in the device. Also in this case, the metal oxide film restrains hole injection so that the abruptness in the rising of the luminance in response to voltage increase in the luminance-voltage characteristic is more alleviated and higher luminous efficiency is provided.

The metal oxide film is preferably formed by helicon sputtering. Thus, the metal oxide film may be thin and dense.

A method of manufacturing an organic electroluminescence device according to another aspect of the invention includes the steps of forming a hole injection electrode, forming a metal oxide film on the hole injection electrode, forming a luminescent layer on the metal oxide film and forming an electron injection electrode on the luminescent layer.

By the method of manufacturing an organic electroluminescence device according to the present invention, the metal oxide film is provided between the hole injection electrode and the luminescent layer, so that the metal oxide film restrains holes from being injected from the hole injection electrode. This improves the charge balance (the balance of positive and negative charges) in the device. As a result, the abruptness in the rising of the luminance in response to voltage increase in the luminance-voltage characteristic is alleviated and higher luminous efficiency is provided.

The metal oxide film is preferably made of a metal oxide selected from the group consisting of gallium oxide, tantalum oxide, lanthanum oxide, indium oxide, tin oxide and platinum oxide. In this case, the metal oxide film can be thin and dense.

The metal oxide film preferably has a thickness in the range from 1 Å to 100 Å. In this case, the metal oxide film restrains holes from being injected into the luminescent layer from the hole injection electrode, while some holes are injected into the luminescent layer from the hole injection electrode by the tunneling effect. When the film thickness is larger than 100 Å, holes are extremely restrained from being injected, and then the luminous efficiency is lowered rather than improved. If the film thickness is smaller than 1 Å, the effect of alleviating the abruptness in the rising of the luminance in response to voltage increase in the luminance-voltage characteristic is weakened.

The metal oxide film more preferably has a thickness in the range from 5 Å to 20 Å. In this case, the abruptness in the rising of the luminance in response to voltage increase in the luminance-voltage characteristic is more alleviated and higher luminous efficiency is provided.

The method of manufacturing an organic electroluminescence device may further include the step of forming a hole injection layer on the hole injection electrode, and the step of forming the luminescent layer may include forming the luminescent layer on the hole injection layer.

In this case, the metal oxide film restrains holes from being injected into the hole injection layer from the hole injection electrode. As a result, the abruptness in the rising of the luminance in response to voltage increase in the luminance-voltage characteristic is more alleviated and higher luminous efficiency is provided.

The hole injection layer may include an amine-based material. The method of manufacturing an organic electroluminescence device may further include the step of forming an electron transport layer on the luminescent layer, and the step of forming the electron injection electrode may include forming the injection electrode on the electron transport layer.

The electron transport layer may include Alq.

The metal oxide film is preferably formed by helicon sputtering. Thus, the metal oxide film can be thin and dense.

The foregoing and other objects, features, aspects and advantages of the present invention will become more apparent from the following detailed description of the present invention when taken in conjunction with the accompanying drawings.

### IN THE DRAWINGS:

Fig. 1 is a schematic diaphragm of an example of an organic EL device;
Fig. 2 is a graph showing the measurement result of the luminance-current density characteristic in organic EL devices in the inventive examples 1 to 3 and the comparative example 1;
Fig. 3 is a graph showing the measurement result of the luminous efficiency-current density characteristic in the organic EL devices in the inventive examples 1 to 3 and the comparative example 1;
Fig. 4 is a graph showing the measurement result of the luminance-voltage characteristic in the organic EL devices in the inventive examples 1 to 3 and the comparative example 1; and
Fig. 5 is a graph showing the measurement result of the luminous efficiency-luminance characteristic in the organic EL devices in the inventive examples 1 to 3 and the comparative example 1.

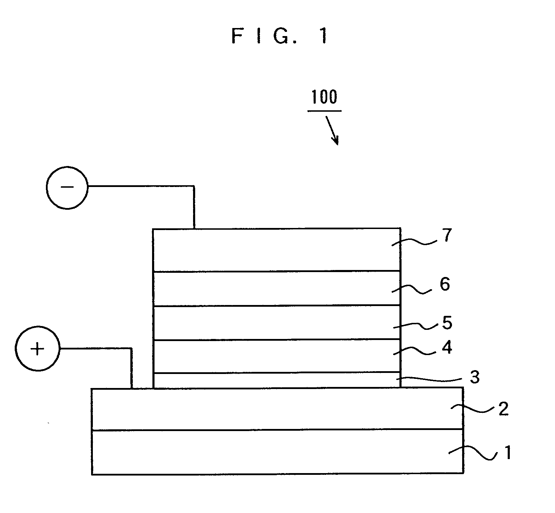

Fig. 1 is a schematic diagram of an example of an organic electroluminescence device (hereinafter referred to as "organic EL device").

In the organic EL device 100 shown in Fig. 1, a hole injection electrode (positive electrode) 2 of a transparent conductive film is formed on a glass substrate 1. A metal oxide film 3 is formed on the hole injection electrode 2. A hole injection layer 4, a luminescent layer 5, and an electron transport layer 6 are formed in this order on the metal oxide film 3. These layers are each made of an organic material. An electron injection electrode (negative electrode) 7 is formed on the electron transport layer 6.

The metal oxide film 3 is preferably made of tantalum oxide, gallium oxide, lanthanum oxide, indium oxide, tin oxide or platinum oxide. Thus, the metal oxide film 3 can be thin and dense.

The thickness of the metal oxide film 3 is preferably in the range from 1 Å to 100 Å, more preferably in the range from 5 Å to 20 Å, and even more preferably about 10 Å. In this case, the metal oxide film 3 restrains holes from being injected into the hole injection layer 4 from the hole injection electrode 2, while some holes are injected into the hole injection layer 4 from the hole injection electrode 2 by the tunneling effect.

The metal oxide film 3 is preferably formed by helicon sputtering (inductive coupling RF plasma assisted magnetron sputtering). Thus, the metal oxide film 3 can be thin and dense.

The luminescent layer 5 may be made of a low molecular organic material, or a high molecular organic material.

Voltage is applied between the hole injection electrode 2 and the electron injection electrode 7 in the organic EL device 100, so that the luminescent layer 5 in the organic EL device 100 irradiates, and the light is emitted from the back surface of the glass substrate 1.

In the organic EL device 100 in Fig. 1, the metal oxide film 3 is inserted between the hole injection electrode 2 and the hole injection layer 4. This alleviates the abruptness in the rising of the luminance in response to voltage increase in the luminance-voltage characteristic, and high luminous efficiency is provided.

Note that the organic EL device may have any of various different structures other than the above-described structure. For example, tow layers, a hole injection layer and a luminescent layer may be provided between the hole injection electrode 2 and the electron injection electrode 7. Three layers, a hole injection layer, a hole transport layer and a luminescent layer may be provided between the hole injection electrode 2 and the electron injection electrode 7. Alternatively, five layers, a hole injection layer, a hole transport layer, a luminescent layer, an electron transport layer and an electron injection layer may be provided between the hole injection electrode 2 and the electron injection electrode 7, or any of these five layers may be omitted.

### Inventive Examples

Organic EL devices according to inventive examples 1 to 12 and comparative examples 1 and 2 were produced, and measured for their luminescent characteristic.

For the inventive examples 1 to 3 and the comparative example 1, the effects of the presence/absence of the metal oxide film and different film thicknesses were examined.

The organic EL devices according to the inventive examples 1 to 3 have the structure as shown in Fig. 1. The hole injection electrode (positive electrode) 2 is made of indium-tin oxide (ITO). The hole injection layer 4 has a thickness of 500 Å and is made of 2TNATA having the molecular structure expressed by the following formula (1). The luminescent layer 5 has a thickness of 150 Å and includes NPB having the molecular structure expressed by the following formula (2) as a host material and 5 percent rubrene (expressed by the following formula (3)) by weight to the host material as a luminescent dopant. The electron transport layer 6 has a thickness of 350 Å and includes Alq having the molecular structure expressed by the following formula (4). The electron injection electrode (negative electrode) 7 is made of a MgIn alloy (in the ratio of 10: 1) as thick as 2000 Å. The material of the luminescent layer 3 is a low molecular organic material and emits yellow light.

The NPB described above is N, N'-di (naphthalene-1-yl)-N, N'-diphenyl-benzidine.

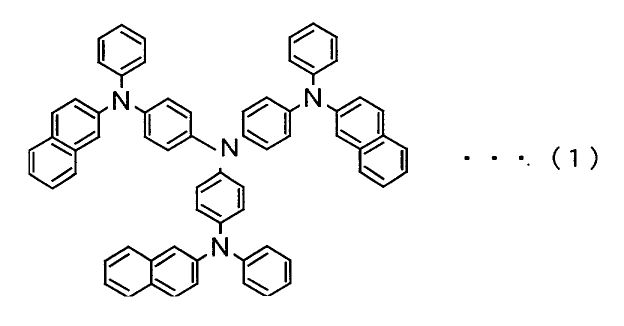

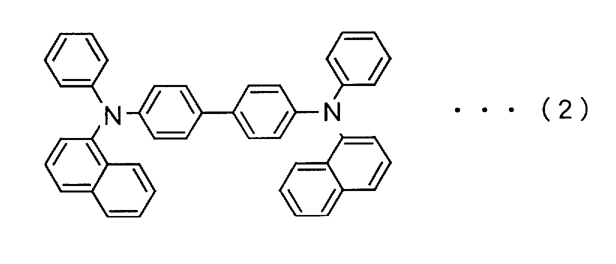

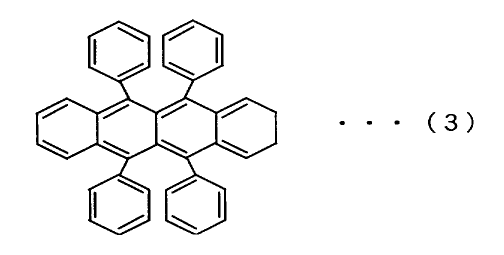

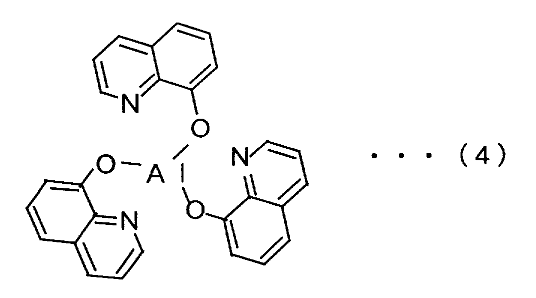

Here, the organic EL device having the structure described above was produced as follows. A hole injection electrode 2 of indium-tin oxide (ITO) was formed on a glass substrate 1. Then, the glass substrate 1 provided with the hole injection electrode 2 was cleaned with a neutral detergent and then subjected to ultrasonic cleaning for ten minutes in acetone and for another ten minutes in ethanol. The surface of the glass substrate 1 was cleaned by an ozone cleaner.

Then, a metal oxide film 3 of gallium oxide (Ga₂O₃) was formed on the hole injection electrode 2 of the ITO by helicon sputtering. The sputtering was performed at a pressure of 2.0 × 10⁻³ Torr, with 200 W upon a target (2.5 in.) and 50 W upon a coil, with no radical gun discharge, at an Ar gas flow rate of 8 sccm, and an O₂ gas flow rate of 10 sccm, as the substrate temperature was not controlled.

Then, a hole injection layer 4, a luminescent layer 5, an electron transport layer 6, and an electron injection electrode 7 were sequentially deposited on the metal oxide film 3 by vacuum evaporation. They were all deposited at ordinary temperature at a vacuum degree of 1 × 10⁻⁶ Torr without controlling the substrate temperature.

The thickness of the metal oxide film 3 was 10 Å (= 1 nm) in the inventive example 1, 20 Å (= 2 nm) in the inventive example 2, and 40 Å (= 4 nm) in the inventive example 3.

The organic EL device in the comparative example 1 was produced under the same conditions as those of the inventive examples 1 to 3 except that the metal oxide film 3 was not formed.

Positive bias voltage was applied to the hole injection electrode 2 of the organic EL device and negative bias voltage was applied to the electron injection electrode 6 in the inventive examples 1 to 3 and the comparative example 1, and the luminescent characteristic was measured.

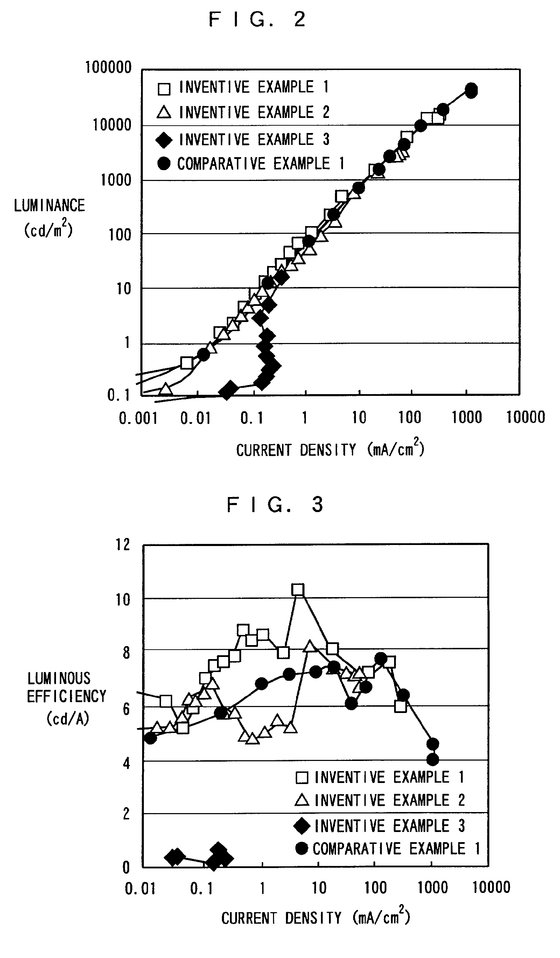

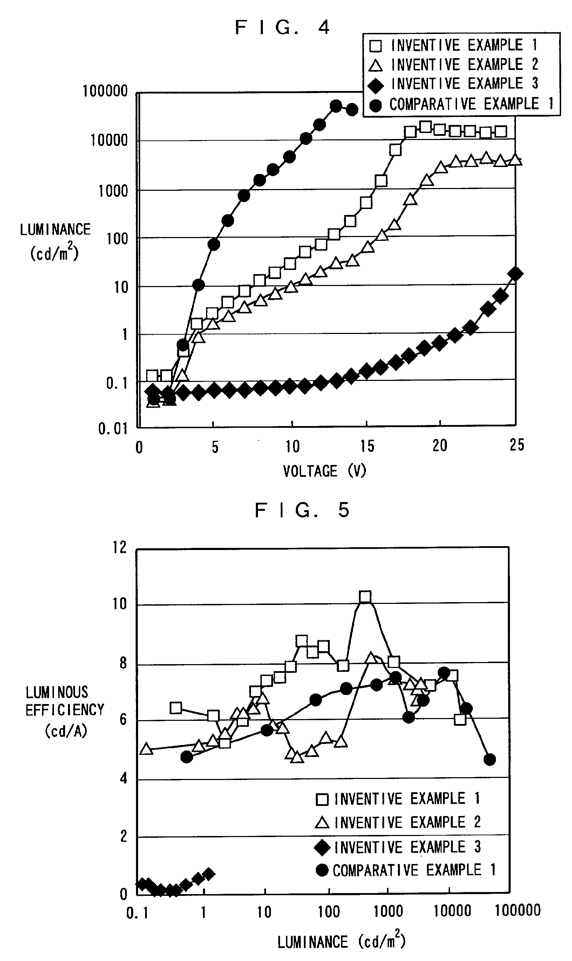

Fig. 2 is a graph showing the measurement result of the luminance-current density characteristic in the organic EL device in the inventive examples 1 to 3 and the comparative example 1. Fig. 3 is a graph showing the measurement result of the luminous efficiency-current density characteristic in the organic EL device in the inventive examples 1 to 3 and the comparative example 1. Fig. 4 is a graph showing the measurement result of the luminance-voltage characteristic in the organic EL device in the inventive examples 1 to 3 and the comparative example 1. Fig. 5 is a graph showing the measurement result of the luminous efficiency-luminance characteristic in the organic EL device in the inventive examples 1 to 3 and the comparative example 1.

As shown in Fig. 2, in the inventive examples 1 and 2 and the comparative example 1, the luminance increased in proportion with the current density, while in the inventive example 3, the luminance was not in proportion with the current density.

As shown in Fig. 3, in the inventive examples 1 and 2 and comparative example 1, sufficient luminous efficiency was provided in a wide range of the current density, while the luminous efficiency was low in the inventive example 3.

As shown in Fig. 4, in the comparative example 1, the rising of the luminance curve in response to voltage increase was abrupt, while in the inventive example 1, the rising of the luminance curve in response to voltage increase was gentler than that in the comparative example 1. In the inventive example 2, the rising of the luminance curve in response to voltage increase was even gentler than that in the comparative example 1. In the inventive example 3, the rising of the luminance curve in response to voltage increase was gentler than that in the inventive example 2, but the luminance was low.

As shown in Fig. 5, in the inventive examples 1 and 2 and the comparative example 1, sufficient luminous efficiency was provided in a wide range of the luminance, while the luminous efficiency was low in the inventive example 3.

Table 1 shows the luminance, the luminance increase ratio, and the luminous efficiency in the inventive examples 1 to 3 and the comparative example 1. Table 1 shows the luminance (cd/m²) at 5 V and 10 V, the luminance increase ratio (luminance at 10 V/luminance at 5 V) and the luminous efficiency (cd/A) at 1000 cd/m².

**[Table 1]**

| | metal oxide film | metal oxide film thickness (Å) | luminance (cd/m²) at 5 V | luminance (cd/m²) at 10 V | luminance increase ratio: luminance [10 V]/ luminance [5 V] | luminous efficiency (cd/A) at 1000 cd/m² |
|---|---|---|---|---|---|---|
| inventive example 1 | gallium oxide | 10 | 2.4 | 28 | 11.67 | 10 |
| inventive example 2 | gallium oxide | 20 | 2.4 | 9.8 | 4.08 | 8 |
| inventive example 3 | gallium oxide | 40 | 0.06 | 0.07 | 1.17 | no light emission |
| comparative example 1 | none | 0 | 72 | 4470 | 62.08 | 7 |

As shown in Table 1, the luminance increase ratio is lower in the inventive example 1 than that in the comparative example 1. In the inventive example 2, the luminance increase ratio is even lower than that in the comparative example 1. In the inventive example 1, the luminous efficiency is higher than that in the comparative example 1. In the inventive example 2, the luminous efficiency is slightly higher than that in comparative example 1. In the inventive example 3, there was no light emission at 1000 cd/m².

As can be seen from Figs. 2 to 5 and the result in Table 1, when the thickness of the metal oxide film 3 is 10 Å and 20 Å, the rising of the luminance in response to voltage increase in the luminance-voltage characteristic is alleviated, and sufficient luminous efficiency is provided. When the thickness of the metal oxide film 3 is 10 Å in particular, the rising of the luminance in response to voltage increase in the luminance-voltage characteristic is alleviated, and high luminous efficiency is provided.

The effects of different materials used for the metal oxide film 3 in the luminescent characteristic were examined in the inventive examples 4 to 8.

The organic EL devices in the inventive examples 4 to 8 were produced under the same conditions as those of the inventive example 1 except that the metal oxide films 3 made of tantalum oxide, lanthanum oxide, indium oxide, tin oxide and platinum oxide respectively were used instead of the metal oxide film 3 of gallium oxide.

Table 2 shows the luminance, the luminance increase ratio, and the luminous efficiency in the inventive examples 4 to 8. Table 2 shows the luminance (cd/m²) at 5 V and 10 V, the luminance increase ratio (luminance at 10 V/luminance at 5 V) and the luminous efficiency (cd/A) at 1000 cd/m².

**[Table 2]**

| | metal oxide film | metal oxide film thickness (Å) | luminance (cd/m²) at 5 V | luminance (cd/m²) at 10 V | luminance increase ratio: luminance [10 V]/ luminance [5 V] | luminous efficiency (cd/A) at 1000 cd/m² |
|---|---|---|---|---|---|---|
| inventive example 4 | tantalum oxide | 10 | 26 | 343 | 13.19 | 10 |
| inventive example 5 | lanthanum oxide | 10 | 22 | 370 | 16.82 | 10 |
| inventive example 6 | indium oxide | 10 | 65 | 3200 | 49.23 | 7.5 |
| inventive example 7 | tin oxide | 10 | 30 | 550 | 18.33 | 9 |
| inventive example 8 | platinum oxide | 10 | 26 | 343 | 13.19 | 9 |

As shown in Table 2, in the inventive examples 4 to 8, the luminance increase ratio is lower than that in the comparative example 1. In the inventive examples 4, 5, 7, and 8, the luminous efficiency is sufficiently high as compared to the above comparative example 1. In the inventive example 6, the luminous efficiency is slightly higher than that in the comparative example 1.

As can be seen from the result in Table 2, when the metal oxide film 3 is made of tantalum oxide, lanthanum oxide, indium oxide, tin oxide or platinum oxide, the rising of the luminance in response to voltage increase in the luminance-voltage characteristic is alleviated similarly to the case of using the metal oxide film 3 of gallium oxide, and sufficient luminous efficiency is provided.

Then in the inventive example 9 and the comparative example 2, the luminescent characteristic obtained when a high molecular organic material was used was examined.

The organic EL device in the inventive example 9 has a hole injection electrode 2, a metal oxide film 3, a luminescent layer 5 and an electron injection electrode 7 in this order. The hole injection electrode (positive electrode) 2 is made of indium-tin oxide (ITO). The luminescent layer 5 is as thick as 1200 Å and made of a polyphenylenevinylene (PPV) derivative. The electron injection electrode (negative electrode) 7 is made of a MgIn alloy as thick as 2000 Å. The material of the luminescent layer 5 is a high molecular organic material and emits yellow light.

The organic EL device in the inventive example 9 was produced under the same conditions as those of the organic EL device in the inventive example 1 except that the material of the luminescent layer 5 was a high molecular organic material, and the hole injection layer 4 and the electron transport layer 6 were not formed.

The organic EL device in the comparative example 2 was produced under the same conditions as those of the inventive example 9 except that the metal oxide film 3 was not formed.

Table 3 shows the luminance, the luminance increase ratio, and the luminous efficiency in the inventive example 9 and the comparative example 2. Table 3 shows the luminance (cd/m²) at 4 V and 7 V, the luminance increase ratio (luminance at 7 V/luminance at 4 V) and the luminous efficiency (cd/A) at 1000 cd/m².

**[Table 3]**

| | metal oxide film | metal oxide film thickness (Å) | luminance (cd/m²) at 4 V | luminance (cd/m²) at 7 V | luminance increase ratio: luminance [4 V]/ luminance [7 V] | luminous efficiency (cd/A) at 1000 cd/m² |
|---|---|---|---|---|---|---|
| inventive example 9 | gallium oxide | 10 | 30 | 1500 | 50.00 | 12 |
| comparative example 2 | none | 0 | 72 | 7500 | 104.17 | 11.5 |

As shown in Table 3, in the inventive example 9, the luminance increase ratio is about half that in the comparative example 2. In the inventive example 9, the luminous efficiency is slightly higher than that in the comparison example 2.

As can be seen from the results in Table 3, similarly to the case of using the low molecular organic material, when a high molecular organic material is used as the material of the luminescent layer 5, the rising of the luminance in response to voltage increase in the luminance-voltage characteristic is alleviated and sufficient luminous efficiency is provided.

Although the present invention has been described and illustrated in detail, it is clearly understood that the same is by way of illustration and example only and is not to be taken by way of limitation, the spirit and scope of the present invention being limited only by the terms of the appended claims.

## Claims

1. An organic electroluminescence device, comprising:
a hole injection electrode;
an electron injection electrode;
a luminescent layer provided between said hole injection electrode and said electron injection electrode; and
a metal oxide film provided between said hole injection electrode and said luminescent layer.

2. The organic electroluminescence device according to claim 1, wherein
said metal oxide film is made of a metal oxide selected from the group consisting of gallium oxide, tantalum oxide, lanthanum oxide, indium oxide, tin oxide, and platinum oxide.

3. The organic electroluminescence device according to claim 1, wherein
said metal oxide film has a thickness in the range from 1 Å to 100 Å.

4. The organic electroluminescence device according to claim 1, wherein
said metal oxide film has a thickness in the range from 5 Å to 20 Å.

5. The organic electroluminescence device according to claim 1, further comprising a hole injection layer provided between said metal oxide film and said luminescent layer.

6. The organic electroluminescence device according to claim 5, wherein
said hole injection layer includes an amine-based material.

7. The organic electroluminescence device according to claim 1, further comprising an electron transport layer provided between said luminescent layer and said electron injection electrode.

8. The organic electroluminescence device according to claim 7, wherein
said electron transport layer includes tris (8-hydroxyquinolinato) aluminum.

9. The organic electroluminescence device according to claim 1, wherein
said metal oxide film is formed by helicon sputtering.

10. A method of manufacturing an organic electroluminescence device, comprising the steps of:
forming a hole injection electrode;
forming a metal oxide film on said hole injection electrode;
forming a luminescent layer on said metal oxide film; and
forming an electron injection electrode on said luminescent layer.

11. The method of manufacturing an organic electroluminescence device according to claim 10, wherein
said metal oxide film is made of a metal oxide selected from the group consisting of gallium oxide, tantalum oxide, lanthanum oxide, indium oxide, tin oxide and platinum oxide.

12. The method of manufacturing an organic electroluminescence device according to claim 10, wherein
said metal oxide film has a thickness in the range from 1 Å to 100 Å.

13. The method of manufacturing an organic electroluminescence device according to claim 10, wherein
said metal oxide film has a thickness in the range from 5 Å to 20 Å.

14. The method of manufacturing an organic electroluminescence device according to claim 10, further comprising the step of forming a hole injection layer on said hole injection electrode,
the step of forming said luminescent layer comprising forming said luminescent layer on said hole injection layer.

15. The method of manufacturing an organic electroluminescence device according to claim 14, wherein
said hole injection layer includes an amine-based material.

16. The method of manufacturing an organic electroluminescence device according to claim 10, further comprising the step of forming an electron transport layer on said luminescent layer,
the step of forming said electron injection electrode comprising forming said electron injection electrode on said electron transport layer.

17. The method of manufacturing an organic electroluminescence device according to claim 16, wherein
said electron transport layer includes tris (8-hydroxyquinolinato) aluminum.

18. The method of manufacturing an organic electroluminescence device according to claim 10, wherein
said step of forming said metal oxide film comprises forming said metal oxide film by helicon sputtering.
